# EUROPEAN PATENT APPLICATION

(11) **EP 4 716 018 A1**
(43) Date of publication of application: **25.03.2026**
(21) Application number: 24818337.8
(22) Date of filing: 22.03.2024
(51) Int. Cl.: H01R 13/02, H01R 12/71, H01R 13/648

(54) **ELECTRICAL CONNECTION STRUCTURE AND ELECTRONIC DEVICE**

(30) Priority: 09.06.2023 CN 202310688789
(71) Applicant: Honor Device Co., Ltd., Shenzhen, Guangdong 518040 (CN)
(72) Inventor: ZHU, Kaixiang, Shenzhen, Guangdong 518040 (CN); WU, Dong, Shenzhen, Guangdong 518040 (CN); MA, Ning, Shenzhen, Guangdong 518040 (CN); HUO, Shuaike, Shenzhen, Guangdong 518040 (CN); XUE, Kangle, Shenzhen, Guangdong 518040 (CN)
(74) Representative: Goddar, Heinz J.
(86) International application number: PCT/CN2024/083335
(87) International publication number: WO 2024/250800

(57) **Abstract**

This application provides an electrical connection structure and an electronic device, and relates to the field of interconnection technologies of a circuit board, to reduce a size of a circuit board and increase sizes of other components around the circuit board. The electrical connection structure includes a circuit board, a first connector, a third group of terminals, and a fourth group of terminals. The circuit board includes a first group of signal traces, a second group of signal traces, a first reference ground, and a second reference ground. The first reference ground and the second reference ground are spaced apart from each other. The first connector is arranged on the circuit board. The first connector includes a first group of terminals and a second group of terminals. The third group of terminals are electrically connected to the first group of terminals by using the first group of signal traces and the first reference ground. The fourth group of terminals are electrically connected to the second group of terminals by using the second group of signal traces and the second reference ground. The electrical connection structure provided in this application is used for circuit board interconnection.

## Description

This application claims priority to Chinese Patent Application No. 202310688789.3, filed with the China National Intellectual Property Administration on June 9, 2023 and entitled "ELECTRICAL CONNECTION STRUCTURE AND ELECTRONIC DEVICE", which is incorporated herein by reference in its entirety.

### TECHNICAL FIELD

This application relates to the field of interconnection technologies of a circuit board, and in particular, to an electrical connection structure and an electronic device.

### BACKGROUND

Two or more circuit boards are usually arranged in an electronic device like a mobile phone, a tablet computer, or a notebook computer. For example, a main board and a secondary board are arranged in the mobile phone. The circuit boards may be interconnected by using an electrical connection structure including a flexible printed circuit (flexible printed circuit, FPC) and a connector.

A signal transmitted between the circuit boards may include a radio frequency signal and a baseband signal. A spectrum range of the baseband signal is wide, and may include a signal whose frequency range is the same as a frequency range of the radio frequency signal. Therefore, interference easily occurs between the baseband signal and the radio frequency signal. To resolve the problem, a connector configured to transmit the radio frequency signal and a connector configured to transmit the baseband signal in the electronic device are generally independently arranged and spaced apart from each other by a particular distance, to reduce crosstalk between the radio frequency signal and the baseband signal.

However, in this way, a quantity of connectors arranged in the electronic device is large, resulting in a large footprint of the connectors on the circuit board. Consequently, a size of the circuit board is large, limiting a size of another component around the circuit board.

### SUMMARY

This application provides an electrical connection structure and an electronic device, to reduce a size of a circuit board and increase a size of another component around the circuit board.

To achieve the foregoing objective, the following technical solutions are used in embodiments of this application:
According to a first aspect, an electrical connection structure is provided. The electrical connection structure includes a circuit board, a first connector, a third group of terminals, and a fourth group of terminals. The circuit board includes a first group of signal traces, a second group of signal traces, a first reference ground, and a second reference ground. The first reference ground faces the first group of signal traces. The second reference ground faces the second group of signal traces. The first reference ground and the second reference ground are spaced apart from each other. The first connector is arranged on the circuit board. The first connector includes a first group of terminals and a second group of terminals. The third group of terminals and the fourth group of terminals are arranged on the circuit board. The third group of terminals are electrically connected to the first group of terminals by using the first group of signal traces and the first reference ground. The fourth group of terminals are electrically connected to the second group of terminals by using the second group of signal traces and the second reference ground.

In this way, a first type of signal may be transmitted by using the first group of terminals, the first group of signal traces, the first reference ground, and the third group of terminals, and a second type of signal may be transmitted by using the second group of terminals, the second group of signal traces, the second reference ground, and the fourth group of terminals. Because the first reference ground and the second reference ground are spaced apart from each other, the first type of signal and the second type of signal are not common-grounded with each other, so that interference is small and an isolation degree is high. In addition, the first group of terminals and the second group of terminals are located in the first connector, and the first type of signal and the second type of signal are introduced to the circuit board or output from the circuit board by using the first connector. Therefore, a quantity of connectors arranged on the electrical connection structure and an external circuit board can be reduced, and sizes of the electrical connection structure and the external circuit board can be reduced, thereby increasing a volume of another component (like a battery) arranged around the electrical connection structure and the external circuit board in an electronic device.

In a possible implementation of the first aspect, the circuit board includes a first metal layer and a second metal layer that are stacked and spaced away from each other. The first group of signal traces are formed by at least a part of the first metal layer. The first reference ground includes a first reference ground part. The first reference ground part is formed by at least a part of the second metal layer. An orthographic projection of at least a part of the first group of signal traces on the second metal layer is located in the first reference ground part. In this way, the at least a part of the first group of signal traces may be shielded by using the first reference ground part, thereby improving anti-interference performance of the first group of signal traces.

In a possible implementation of the first aspect, when the first group of signal traces are formed by a part of the first metal layer and the first reference ground part is formed by a part of the second metal layer, the second group of signal traces include first part of signal traces. The first part of signal traces are formed by another part of the second metal layer. The first part of signal traces and the first reference ground part are spaced apart from each other. The second reference ground includes a second reference ground part. The second reference ground part is formed by another part of the first metal layer. The second reference ground part and the first group of signal traces are spaced apart from each other. An orthographic projection of at least a part of the first part of signal traces on the first metal layer is located in the second reference ground part. In this way, the at least a part of the first part of signal traces may be shielded by using the second reference ground part, thereby improving anti-interference performance of the first part of signal traces.

In a possible implementation of the first aspect, the second reference ground further includes a third reference ground part and a fourth reference ground part. The third reference ground part and the fourth reference ground part are formed by another part of the second metal layer. The third reference ground part and the fourth reference ground part are electrically connected to the second reference ground part. The third reference ground part is located on one side of the first part of signal traces, and the fourth reference ground part is located on the other side of the first part of signal traces. In this way, the first part of signal traces may be shielded in a plane on which the second metal layer is located by using the third reference ground part and the fourth reference ground part, thereby improving the anti-interference performance of the first part of signal traces. In addition, an area of the second reference ground is increased, thereby improving signal return performance. In addition, on the premise of ensuring that the area of the second reference ground remains unchanged, a part of the second reference ground is arranged on the first metal layer, and another part of the second reference ground is arranged on the second metal layer. In this way, through the stacked arrangement, a footprint of a second signal transmission assembly on the circuit board can be reduced, thereby helping reduce a volume of the electrical connection structure and facilitating mounting in the electronic device with limited space.

In a possible implementation of the first aspect, the circuit board further includes a third metal layer. The third metal layer is located on a side of the first metal layer facing away from the second metal layer. The third metal layer and the first metal layer are stacked and spaced away from each other. The first reference ground further includes a fifth reference ground part. The fifth reference ground part is formed by at least a part of the third metal layer. The fifth reference ground part is electrically connected to the first reference ground part. An orthographic projection of at least a part of the first group of signal traces on the third metal layer is located in the fifth reference ground part. In this way, the at least a part of the first group of signal traces may be shielded by using the fifth reference ground part, thereby further improving the anti-interference performance of the first group of signal traces.

In a possible implementation of the first aspect, when the fifth reference ground part is formed by a part of the third metal layer, the second group of signal traces further include a second part of signal traces. The second part of signal traces are formed by another part of the third metal layer. An orthographic projection of at least a part of the second part of signal traces on the first metal layer is located in the second reference ground part. In this way, the second part of signal traces and the first part of signal traces may be isolated from each other by using the second reference ground part, thereby avoiding interference between the second part of signal traces and the first part of signal traces.

In a possible implementation of the first aspect, the second reference ground further includes a sixth reference ground part and a seventh reference ground part. The sixth reference ground part and the seventh reference ground part are formed by another part of the third metal layer. The sixth reference ground part and the seventh reference ground part are electrically connected to the second reference ground part. The sixth reference ground part is located on one side of the second part of signal traces, and the seventh reference ground part is located on the other side of the second part of signal traces. In this way, the second part of signal traces may be shielded in a plane on which the third metal layer is located by using the sixth reference ground part and the seventh reference ground part, thereby improving anti-interference performance of the second part of signal traces. In addition, the area of the second reference ground is increased, thereby improving signal return performance. In addition, on the premise of ensuring that the area of the second reference ground remains unchanged, another part of the second reference ground is arranged on the third metal layer. In this way, through the stacked arrangement, the footprint of the second signal transmission assembly on the circuit board can be reduced, thereby helping reduce the volume of the electrical connection structure and facilitating mounting in the electronic device with the limited space.

In a possible implementation of the first aspect, the circuit board includes a first metal layer. The first reference ground includes an eighth reference ground part and a ninth reference ground part. The first group of signal traces are formed by a part of the first metal layer. The eighth reference ground part and the ninth reference ground part are formed by another part of the first metal layer. The eighth reference ground part is located on one side of at least a part of the first group of signal traces, and the ninth reference ground part is located on the other side of the at least a part of the first group of signal traces. In this way, the at least a part of the first group of signal traces may be shielded by using the eighth reference ground part and the ninth reference ground part. In addition, the eighth reference ground part, the ninth reference ground part, and the at least a part of the first group of signal traces located between the eighth reference ground part and the ninth reference ground part form a coplanar waveguide. An insertion loss of the coplanar waveguide is small, thereby helping improve transmission efficiency of a radio frequency signal.

Optionally, the first group of signal traces further include a second segment. The second segment is a part of the first group of signal traces. The eighth reference ground part is located on one side of the second segment, and the ninth reference ground part is located on the other side of the second segment. In this way, the eighth reference ground part, the second segment, and the ninth reference ground part may form a coplanar waveguide structure, thereby reducing an insertion loss of the first group of signal traces to some extent and improving the transmission efficiency of the radio frequency signal.

In a possible implementation of the first aspect, a part of the circuit board on which the second segment, the eighth reference ground part, and the ninth reference ground part are located may pass through a rotating shaft mechanism. The part of the circuit board includes a small quantity of metal layers, and therefore is flexible and easier to be folded.

In a possible implementation of the first aspect, the first group of terminals include one first signal terminal and a plurality of first ground terminals. At least a part of the plurality of first ground terminals are located between the first signal terminal and the second group of terminals. In this way, isolation is formed by using the at least a part of the first ground terminals, thereby avoiding crosstalk between the first type of signal transmitted in the first signal terminal and the second type of signal transmitted in the second group of terminals.

In a possible implementation of the first aspect, the first connector further includes a fifth group of terminals. The fifth group of terminals are located between the first group of terminals and the second group of terminals. A fifth group of pads are arranged on the circuit board. The fifth group of pads are located between the first reference ground and the second reference ground. The fifth group of pads and the first reference ground are spaced apart from each other, and the fifth group of pads and the second reference ground are spaced apart from each other. The fifth group of terminals are soldered to the fifth group of pads. In this way, isolation may be formed by using the fifth group of terminals, thereby avoiding crosstalk between the first type of signal transmitted in the first group of terminals and the second type of signal transmitted in the second group of terminals.

In a possible implementation of the first aspect, the electrical connection structure further includes a first reinforcing member. The first reinforcing member is located on a surface of the circuit board facing away from the first connector. An orthographic projection of the first connector on the circuit board overlaps with an orthographic projection of the first reinforcing member on the circuit board. The first reinforcing member is an insulating member.

Specifically, a material of the first reinforcing member includes, but is not limited to, a non-metal like FR-4 epoxy glass-cloth laminate, polycarbonate, PC+glass fiber, or ABS plastic.

In this way, structural strength of the part of the circuit board to which the first connector is connected can be increased by using the first reinforcing member, thereby facilitating a plug-in operation. In addition, because the first reinforcing member is the insulating member, capacitive coupling effects between the first reference ground and the first reinforcing member, and between the second reference ground and the first reinforcing member can be avoided. In this way, mutual crosstalk between the first reference ground and the second reference ground by using the first reinforcing member is avoided, thereby increasing an isolation degree between the first type of signal and the second type of signal.

In a possible implementation of the first aspect, the electrical connection structure further includes a second connector. The second connector is arranged on the circuit board. The foregoing third group of terminals are a part of terminals of the second connector, and the foregoing fourth group of terminals are another part of the terminals of the second connector. In this way, the third group of terminals and the fourth group of terminals are terminals of the second connector, thereby facilitating managing and repairing.

In a possible implementation of the first aspect, the first group of signal traces are for transmitting a radio frequency signal, and the second group of signal traces are for transmitting a baseband signal. That is, the foregoing first type of signal is the radio frequency signal, and the second type of signal is the baseband signal.

In a possible implementation of the first aspect, the circuit board is a flexible printed circuit.

In a possible implementation of the first aspect, the circuit board includes a first circuit board part and a second circuit board part. An end of the first circuit board part along a length direction of the first circuit board part is connected to an end of the second circuit board part along a length direction of the second circuit board part. The length direction of the first circuit board part intersects with the length direction of the second circuit board part. In this way, the circuit board is approximately L-shaped, and can match a relative location of two connected circuit boards.

In a possible implementation of the first aspect, the circuit board is provided with an opening. The opening includes a first opening part and a second opening part. The first opening part is located at an end portion of the first circuit board part facing the second circuit board part, and the first opening part extends along the length direction of the first circuit board part. The second opening part is arranged at an end portion of the second circuit board part facing the first circuit board part and is in communication with the first opening part, and the second opening part extends along the length direction of the second circuit board part. In this way, stress concentration can be reduced by using the opening, to avoid a problem like redundancy or tearing of the circuit board.

According to a second aspect, an electronic device is further provided. The electronic device includes a first circuit board and the electrical connection structure described in any one of the foregoing technical solutions. A fourth connector is arranged on the first circuit board. A first connector of the electrical connection structure is electrically connected to the fourth connector.

Because the electronic device provided in this application includes the electrical connection structure according to any one of the foregoing technical solutions, they can resolve the same technical problems and achieve the same effects.

In a possible implementation of the second aspect, the electronic device further includes a second circuit board. The third group of terminals and the fourth group of terminals of the electrical connection structure are electrically connected to the second circuit board.

In a possible implementation of the second aspect, the electronic device includes a first screen, a first housing, a second housing, and a rotating shaft mechanism. The first screen includes a first screen part and a second screen part connected to the first screen part. The first screen part is connected to the first housing. The second screen part is connected to the second housing. The rotating shaft mechanism is connected between the first housing and the second housing. The second circuit board is arranged in the first housing. The first circuit board is arranged in the second housing. The electrical connection structure passes through the rotating shaft mechanism.

### BRIEF DESCRIPTION OF DRAWINGS

FIG. 1 is a three-dimensional diagram of an electronic device according to some embodiments of this application;
FIG. 2 is a three-dimensional diagram of the electronic device shown in FIG. 1 viewed in a direction D1;
FIG. 3 is a schematic diagram of a structure when a first screen in the electronic device shown in FIG. 1 is in a folded state;
FIG. 4 is a schematic diagram of a structure of internal components of the electronic device shown in FIG. 2;
FIG. 5A is a schematic diagram of an exploded structure of a first circuit board, a second circuit board, and an electrical connection structure in the electronic device shown in FIG. 4;
FIG. 5B is a partial enlarged view of a region I of the exploded structure shown in FIG. 5A;
FIG. 5C is a partial enlarged view of a region II of the exploded structure shown in FIG. 5A;
FIG. 6A is a schematic diagram of a structure existing when the exploded structure shown in FIG. 5A is viewed in a direction D2;
FIG. 6B is a partial enlarged view of a region III of the exploded structure shown in FIG. 6A;
FIG. 6C is a partial enlarged view of a region IV of the exploded structure shown in FIG. 6A;
FIG. 7 is a schematic diagram of a specific structure of the electrical connection structure in the exploded structure shown in FIG. 6A at a second connector;
FIG. 8 is a schematic diagram of a structure existing when the electrical connection structure shown in FIG. 7 is viewed in a direction D3;
FIG. 9 is a top view of a first metal layer in the circuit board shown in FIG. 8;
FIG. 10 is a top view of a second metal layer in the circuit board shown in FIG. 8;
FIG. 11 is a top view of a third metal layer in the circuit board shown in FIG. 8;
FIG. 12 is a graph of variation of an isolation degree between a first type of signal and a second type of signal transmitted in the electrical connection structure shown in FIG. 7 with a frequency in a simulation experiment;
FIG. 13 is a graph of variation of an isolation degree between a first type of signal and a second type of signal of a comparative electrical connection structure with a frequency in a simulation experiment; and
FIG. 14 is a schematic diagram of a structure of an electronic device according to some other embodiments of this application.

### DESCRIPTION OF EMBODIMENTS

In embodiments of this application, terms "first", "second", "third", "fourth", "fifth", "sixth", "seventh", "eighth", "ninth", "tenth", "eleventh", and "twelfth" are used merely for the purpose of description, and shall not be construed as indicating or implying relative importance or implying a quantity of indicated technical features. Therefore, features defining "first", "second", "third", "fourth", "fifth", "sixth", "seventh", "eighth", "ninth", "tenth", "eleventh", and "twelfth" may explicitly or implicitly include one or more such features.

In embodiments of this application, terms "include", "comprise", and any variants thereof are intended to cover a non-exclusive inclusion. Therefore, in the context of a process, method, object, or apparatus that includes a series of elements, the process, method, object, or apparatus not only includes such elements, but also includes other elements not specified expressly, or may include inherent elements of the process, method, object, or apparatus. Without further limitation, an element defined by the sentence "including a " does not exclude existence of other identical elements in the process, method, article, or apparatus including the element.

Embodiments of this application provide an electronic device. The electronic device may be user equipment (user equipment, UE), a terminal (terminal), or the like. For example, the electronic device may be a mobile terminal or a stationary terminal, such as a tablet computer (portable android device, PAD), a personal digital assistant (personal digital assistant, PDA), a handheld device having a wireless communication function, a computing device, an in-vehicle device, a wearable device, a virtual reality (virtual reality, VR) terminal device, an augmented reality (augmented reality, AR) terminal device, a wireless terminal in industrial control (industrial control), a wireless terminal in self driving (self driving), a wireless terminal in remote medical (remote medical), a wireless terminal in smart grid (smart grid), a wireless terminal in transportation safety (transportation safety), a wireless terminal in a smart city (smart city), or a wireless terminal in a smart home (smart home). A form of the electronic device is not specifically limited in embodiments of this application.

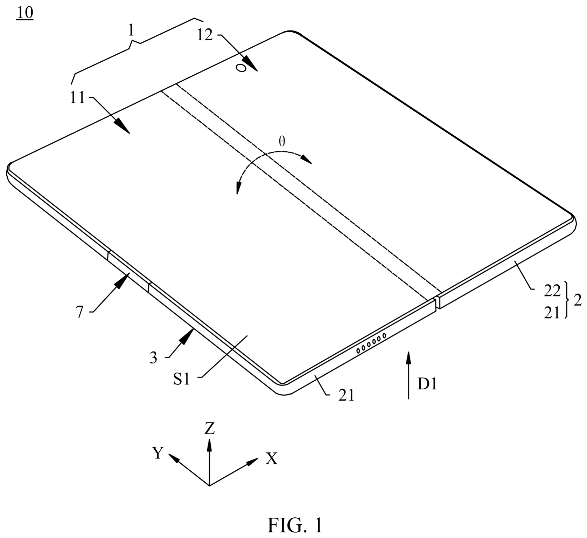

Refer to FIG. 1. FIG. 1 is a three-dimensional diagram of an electronic device 10 according to some embodiments of this application. Embodiments and the following embodiments are described by using an example in which the electronic device 10 is a foldable device. The foldable device may be, for example, a foldable mobile phone. In FIG. 1, the foldable device is in an unfolded state. In this state, the electronic device is approximately in a shape of a rectangular flat plate. Based on this, for ease of description in the following embodiments, an XYZ coordinate system is established for the electronic device 10 in the unfolded state, a length direction of the electronic device 10 is defined as an X-axis direction, a width direction of the electronic device 10 is defined as a Y-axis direction, and a thickness direction of the electronic device 10 is defined as a Z-axis direction. It may be understood that, the coordinate system of the electronic device 10 may be flexibly set based on an actual requirement. This is not specifically limited herein. In some other embodiments, when the electronic device 10 is in the unfolded state, the electronic device 10 may alternatively be in a shape of a square flat plate, a circular flat plate, an elliptical flat plate, or the like.

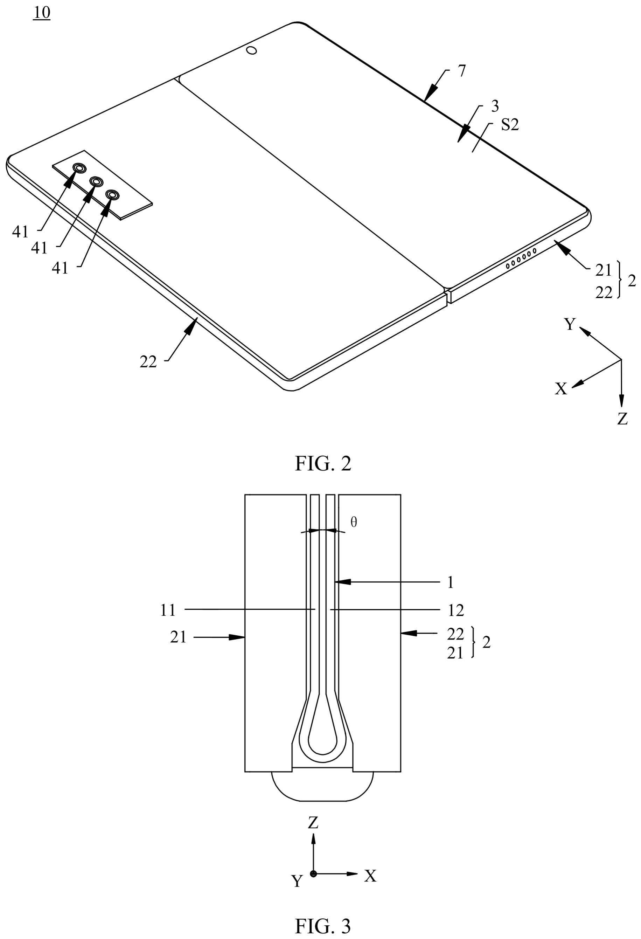

Refer to FIG. 1 and FIG. 2. FIG. 2 is a three-dimensional diagram of the electronic device 10 shown in FIG. 1 viewed in a direction D1. The electronic device 10 includes a first screen 1, a support apparatus 2, and a second screen 3.

It can be understood that FIG. 1 and FIG. 2 schematically show some components included in the electronic device 10. Actual shapes, actual sizes, actual locations, and actual constructions of these components are not limited by those in FIG. 1 and FIG. 2. In some other embodiments, the electronic device 10 may not include the first screen 1 and the second screen 3.

Refer to FIG. 1 mainly. The first screen 1 is used for displaying information such as an image or a video. The first screen 1 may be an organic light-emitting diode (organic light-emitting diode, OLED) screen, a micro organic light-emitting diode (micro organic light-emitting diode) screen, a quantum dot light-emitting diode (quantum dot light emitting diode, QLED) screen, or the like.

The first screen 1 includes a display surface S1. A user can see, from the display surface S1, the image or the video displayed by the first screen 1. The first screen 1 has a back side. The back side is a side of the first screen 1 facing away from the display surface S1.

The support apparatus 2 is located on the back side of the first screen 1, and is fastened to the first screen 1. The support apparatus 2 is used for supporting the first screen 1 and protecting internal components.

In some embodiments, the support apparatus 2 includes a first housing 21 and a second housing 22. When the electronic device 10 is another product, the electronic device 10 may alternatively not include the second housing 22, or may include, in addition to the first housing 21 and the second housing 22, a third housing, a fourth housing, a fifth housing, or the like. This is not specifically limited in this application.

The first housing 21 and the second housing 22 are used for supporting the first screen 1. Specifically, refer to FIG. 1 mainly. The first screen 1 includes a first screen part 11 and a second screen part 12. The first screen part 11 is connected to the second screen part 12 and the first screen part 11 is connected to the first housing 21. The second screen part 12 is connected to the second housing 22.

The second screen 3 is arranged on a side of the first housing 21 facing away from the first screen part 11, and the second screen 3 includes a display surface S2. The display surface S2 of the second screen 3 faces away from the display surface of the first screen part 11. The display surface of the first screen part 11 is a part of region of the foregoing display surface S1 located in the first screen part 11.

The support apparatus 2 further includes a rotating shaft mechanism. The rotating shaft mechanism is connected between the first housing 21 and the second housing 22. The first housing 21 and the second housing 22 may be rotatably connected by using the rotating shaft mechanism, so that the first screen 1 can be folded from the unfolded state shown in FIG. 1 to a folded state. In FIG. 1, a first screen 1 is in the unfolded state. Refer to FIG. 3. FIG. 3 is a schematic diagram of a structure when a first screen 1 in the electronic device 10 shown in FIG. 1 is in a folded state. In this state, the first housing 21 and the second housing 22 protect the first screen 1 outside, to avoid the first screen 1 being scuffed. In addition, the electronic device 10 is folded to facilitate being carried. In addition, the second screen 3 is exposed, so that small-screen display may be implemented by using the second screen 3.

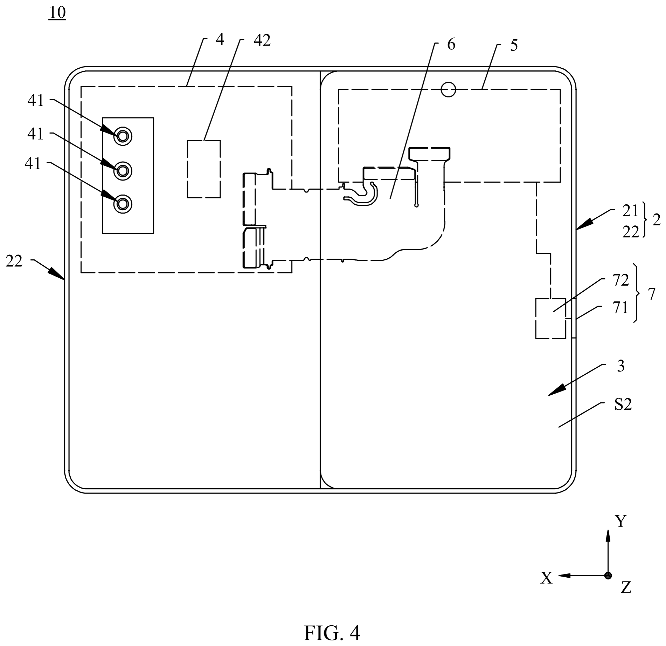

Refer to FIG. 4. FIG. 4 is a schematic diagram of a structure of internal components of the electronic device 10 shown in FIG. 2. It should be noted that, in FIG. 4, the internal components of the electronic device 10 are drawn by using dashed lines. The electronic device 10 further includes a first circuit board 4, a second circuit board 5, an electrical connection structure 6, and an antenna module 7.

Refer to FIG. 4. The first circuit board 4 may be arranged in the second housing 22, and the second circuit board 5 may be arranged in the first housing 21.

The first circuit board 4 may be a main board of the electronic device 10. A rear camera module 41 may be arranged on the first circuit board 4. A radio frequency (radio frequency, RF) transceiver module 42 may be also arranged on the first circuit board 4. The radio frequency transceiver module 42 includes, but is not limited to, a radio frequency transceiver circuit and a radio frequency transceiver chip. The radio frequency transceiver module 42 is used for generating a radio frequency transmit signal and process a radio frequency receive signal.

Based on the foregoing description, still refer to FIG. 4. The electrical connection structure 6 is connected between the first circuit board 4 and the second circuit board 5, and the electrical connection structure 6 passes through the rotating shaft mechanism. The electrical connection structure 6 may transmit the radio frequency transmit signal generated by the radio frequency transceiver module 42 in the first circuit board 4 to the second circuit board 5, and transmit the radio frequency receive signal generated by the second circuit board 5 to the radio frequency transceiver module 42 in the first circuit board 4.

In addition, the electrical connection structure 6 may further transmit a baseband signal. In this embodiment, the baseband signal is a signal other than the radio frequency signal. Specifically, the baseband signal may include a control signal, a video stream signal, an audio electric signal, and the like. The baseband signals have a wide spectrum range, and may include signals whose frequency ranges are the same as the frequency ranges of the radio frequency signals (including the radio frequency transmit signal and the radio frequency receive signal). Therefore, interference easily occurs between the baseband signal and the radio frequency signal.

Still refer to FIG. 4. The antenna module 7 may be arranged in the first housing 21. In some embodiments, the antenna module 7 may include a radiator 71 and a control circuit board 72. The radiator 71 may be formed by at least a part (for example, a border) of the first housing 21. The control circuit board 72 is electrically connected to the radiator 71. The control circuit board 72 is used for switching an operating frequency band or an operating status of the radiator 71. The control circuit board 72 is located inside the first housing 21.

The antenna module 7 is electrically connected to the second circuit board 5, to receive the foregoing radio frequency transmit signal and baseband signals, such as an antenna control signal and a power supply signal, from the second circuit board 5. The radiator 71 transmits the radio frequency transmit signal in a form of an electromagnetic wave, and the control circuit board 72 is used for switching the operating frequency band or the operating status of the radiator 71 based on the antenna control signal. The antenna module 7 is further used for receiving an electromagnetic wave signal, and converting the electromagnetic wave signal into the radio frequency receive signal for transmission to the second circuit board 5.

The following focuses on a specific structure of the electrical connection structure 6.

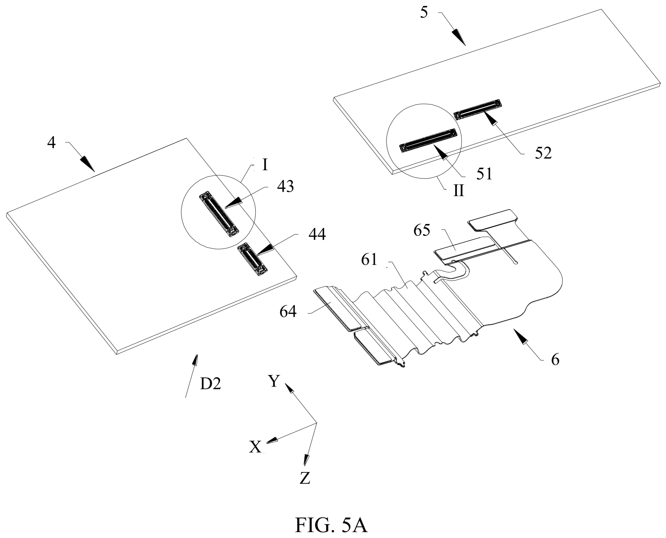

Refer to FIG. 5A. FIG. 5A is a schematic diagram of an exploded structure of a first circuit board 4, a second circuit board 5, and an electrical connection structure 6 in the electronic device 10 shown in FIG. 4.

A fourth connector 43 may be arranged on the first circuit board 4, and a fifth connector 51 may be arranged on the second circuit board 5. The fourth connector 43 is electrically connected to the fifth connector 51 by using the electrical connection structure 6.

It may be understood that, another connector may be further arranged on the first circuit board 4. For example, in the embodiment shown in FIG. 5A, a sixth connector 44 may be further arranged on the first circuit board 4, and a seventh connector 52 may be further arranged on the second circuit board 5. The sixth connector 44 is electrically connected to the seventh connector 52 by using the electrical connection structure 6.

A specific connection structure among the fourth connector 43, the electrical connection structure 6, and the fifth connector 51 is mainly described in the following embodiments.

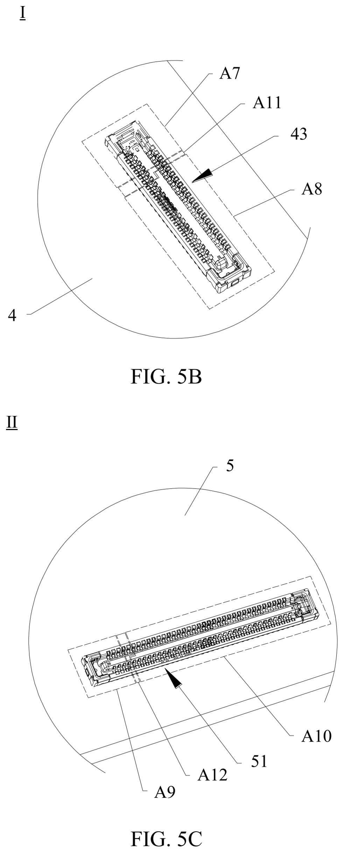

Specifically, refer to FIG. 5B. FIG. 5B is a partial enlarged view of a region I of the exploded structure shown in FIG. 5A. The fourth connector 43 may include a seventh group of terminals A7 and an eighth group of terminals A8. Refer to FIG. 5C. FIG. 5C is a partial enlarged view of a region II of the exploded structure shown in FIG. 5A. The fifth connector 51 may include a ninth group of terminals A9 and a tenth group of terminals A10. The seventh group of terminals A7 are electrically connected to the ninth group of terminals A9 by using the electrical connection structure 6, to transmit a first type of signal. The first type of signal may be the foregoing radio frequency signal. The eighth group of terminals A8 are electrically connected to the tenth group of terminals A10 by using the electrical connection structure 6, to transmit a second type of signal. The second type of signal may be the foregoing baseband signal.

Certainly, in other embodiments, the foregoing first type of signal may alternatively be the baseband signal, and the foregoing second type of signal may alternatively be the radio frequency signal; the first type of signal and the second type of signal are radio frequency signals; or the first type of signal and the second type of signal are baseband signals. In the following embodiments, an example is provided by using the first type of signal as the radio frequency signal and the second type of signal as the baseband signal. This should not be considered as a special limitation to this application.

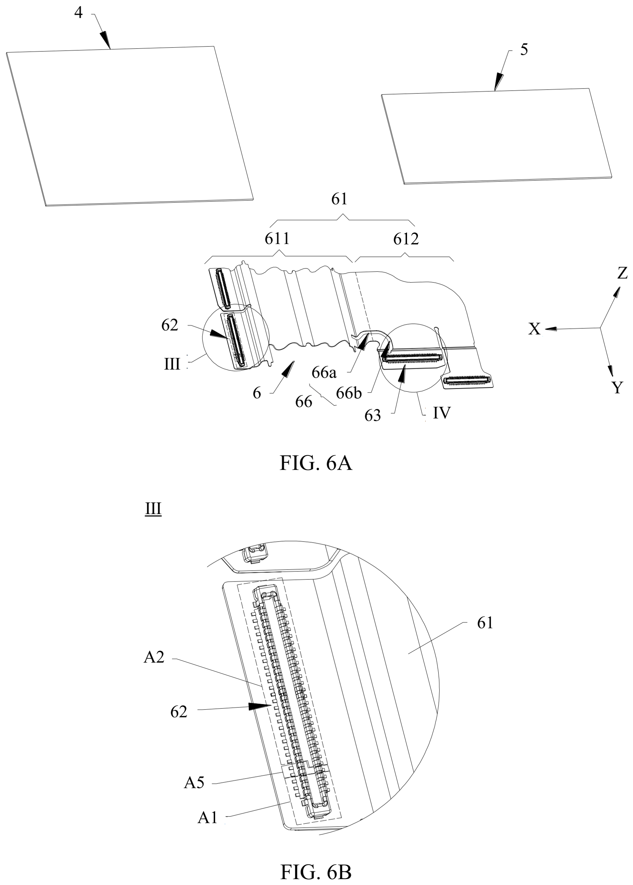

Refer to FIG. 6A. FIG. 6A is a schematic diagram of a structure existing when the exploded structure shown in FIG. 5A is viewed in a direction D2. The electrical connection structure 6 includes a circuit board 61, a first connector 62, and a second connector 63.

The circuit board 61 may be a flexible circuit board, or may be a rigid-flexible circuit board. In the embodiments, an example is provided by using the circuit board 61 as the flexible circuit board. Specifically, the circuit board 61 may be an FPC.

The circuit board 61 may have various shapes. For example, the circuit board 61 may be S-shaped, L-shaped, straight-line shaped, or the like. The shape of the circuit board 61 may be specifically designed according to a relative location of the first circuit board 4 and the second circuit board 5.

In some embodiments, still refer to FIG. 6A. The circuit board 61 may include a first circuit board part 611 and a second circuit board part 612.

The first circuit board part 611 has a length direction. The length direction of the first circuit board part 611 is the same as an extending direction of an internal signal trace of the first circuit board part 611. Specifically, the length direction of the first circuit board part 611 is approximately parallel to the X-axis direction. Similarly, the second circuit board part 612 also has a length direction. The length direction of the second circuit board part 612 is the same as an extending direction of an internal signal trace of the second circuit board part 612. Specifically, the length direction of the second circuit board part 612 is approximately parallel to the Y-axis direction.

Based on the foregoing description, one end of the length direction of the first circuit board part 611 is connected to one end of the length direction of the second circuit board part 612, and the length direction of the first circuit board part 611 intersects with the length direction of the second circuit board part 612. "Intersect" represents an angle, and the angle may be greater than 0° and less than 180°. Optionally, the length direction of the first circuit board part 611 may be approximately perpendicular to the length direction of the second circuit board part 612.

In this way, the circuit board 61 is approximately L-shaped, and can match the relative location of the first circuit board 4 and the second circuit board 5.

Based on the foregoing description, the relative location of the first circuit board 4 and the second circuit board 5 inevitably deviates, and a location of the fourth connector 43 on the first circuit board 4 and a location of the fifth connector 51 on the second circuit board 5 also inevitably deviate. Based on this, after the electrical connection structure 6 is connected to the fourth connector 43 and the fifth connector 51, the circuit board 61 inevitably has a problem like redundancy, wrinkling, or tearing.

To resolve the foregoing problem, in some embodiments, still refer to FIG. 6A. The circuit board 61 is provided with an opening 66. The opening 66 includes a first opening part 66a and a second opening part 66b. The first opening part 66a is located at an end portion of the first circuit board part 611 facing the second circuit board part 612. The first opening part 66a extends approximately along the length direction of the first circuit board part 611. The second opening part 66b is arranged at an end portion of the second circuit board part 612 facing the first circuit board part 611, and is in communication with the first opening part 66a. The second opening part 66b extends along the length direction of the second circuit board part 612.

In this way, stress concentration can be reduced by using the opening 66, to avoid a problem like redundancy or tearing of the circuit board 61.

Still refer to FIG. 6A. The first connector 62 and the second connector 63 are arranged on the circuit board 61. In addition, the first connector 62 and the second connector 63 may be plug-in board-to-board (board-to-board, BTB) connectors. Certainly, in other embodiments, the first connector 62 and the second connector 63 may alternatively be magnetic connectors or contact connectors. This is not specifically limited in this application.

In some embodiments, still refer to FIG. 6A. The first connector 62 may be arranged at an end portion of the first circuit board part 611 facing away from the second circuit board part 612. The second connector 63 may be arranged at an end portion of the second circuit board part 612 facing away from the first circuit board part 611.

The first connector 62 is in cooperation connection with the fourth connector 43, and the second connector 63 is in cooperation connection with the fifth connector 51.

Specifically, refer to FIG. 6B. FIG. 6B is a partial enlarged view of a region III of the exploded structure shown in FIG. 6A. The electrical connection structure includes a first group of terminals A1 and a second group of terminals A2. The first group of terminals A1 and the second group of terminals A2 are arranged on the circuit board 61. Specifically, refer to FIG. 6A and FIG. 6B together. The first group of terminals A1 are a part of terminals of the first connector 62, and the second group of terminals A2 are another part of the terminals of the first connector 62. The first group of terminals A1 are in cooperation connection with the foregoing seventh group of terminals A7, and the second group of terminals A2 are in cooperation connection with the foregoing eighth group of terminals A8.

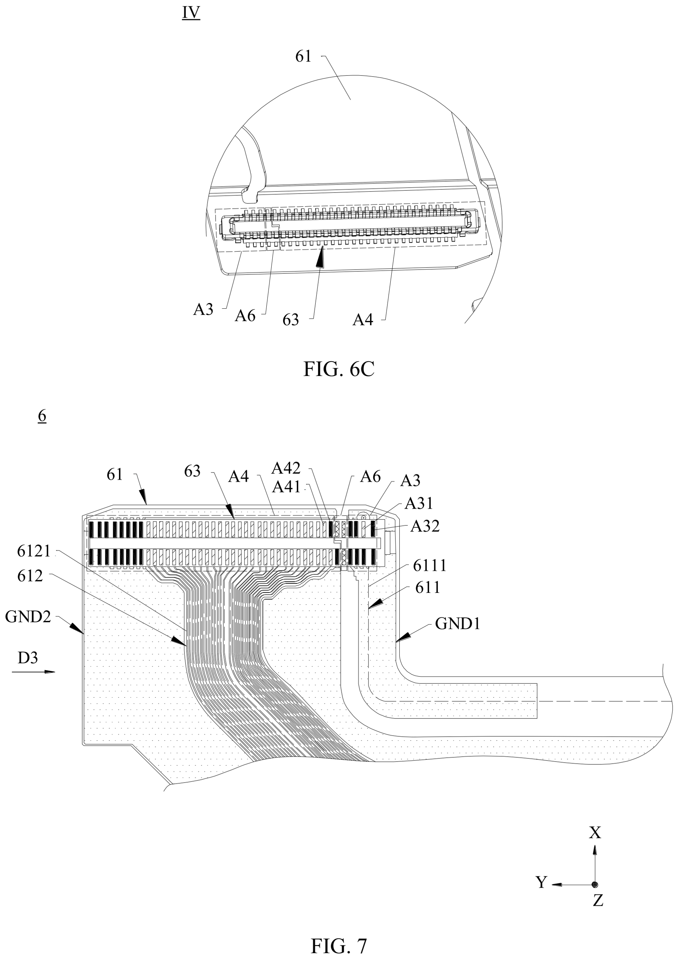

Refer to FIG. 6C. FIG. 6C is a partial enlarged view of a region IV of the exploded structure shown in FIG. 6A. The electrical connection structure 6 further includes a third group of terminals A3 and a fourth group of terminals A4. The third group of terminals A3 and the fourth group of terminals A4 are arranged on the circuit board 61. In some embodiments, refer to FIG. 6A and FIG. 6C together. The third group of terminals A3 are a part of terminals of the second connector 63, and the fourth group of terminals A4 are another part of the terminals of the second connector 63. The third group of terminals A3 are in cooperation connection with the ninth group of terminals A9, and the fourth group of terminals A4 are in cooperation connection with the tenth group of terminals A10.

Refer to FIG. 7. FIG. 7 is a schematic diagram of a specific structure of the electrical connection structure 6 in the exploded structure shown in FIG. 6A at a second connector 63. The circuit board 61 includes a first group of signal traces 611, a second group of signal traces 612, a first reference ground GND1, and a second reference ground GND2. In FIG. 7, the first reference ground GND1 and the second reference ground GND2 are filled with dots.

The first reference ground GND1 faces the first group of signal traces 611.

The second reference ground GND2 faces the second group of signal traces 612. "Face" should be understood as being close to each other. Specifically, that the first reference ground GND1 faces the first group of signal traces 611 is that, for the first reference ground GND1 and the second reference ground GND2, a distance between the first reference ground GND1 and the first group of signal traces 611 is short. That is, the distance between the first reference ground GND1 and the first group of signal traces 611 is less than a distance between the second reference ground GND2 and the first group of signal traces 611.

Similarly, that the second reference ground GND2 faces the second group of signal traces 612 is that, for the first reference ground GND1 and the second reference ground GND2, a distance between the second reference ground GND2 and the second group of signal traces 612 is short. That is, the distance between the second reference ground GND2 and the second group of signal traces 612 is less than a distance between the first reference ground GND1 and the second group of signal traces 612.

The foregoing third group of terminals A3 are electrically connected to the first group of terminals A1 by using the first group of signal traces 611 and the first reference ground GND1, to transmit the foregoing first type of signal. The foregoing fourth group of terminals A4 are electrically connected to the second group of terminals A2 by using the second group of signal traces 612 and the second reference ground GND2, to transmit the foregoing second type of signal.

Specifically, refer to FIG. 7. The third group of terminals A3 may include at least one third signal terminal A31 and at least one third ground terminal A32. In FIG. 7, the third signal terminal A31 is filled with section lines, and the third ground terminal A32 is filled with a black solid.

Correspondingly, the foregoing first group of terminals A1 may include at least one first signal terminal and at least one first ground terminal.

Still refer to FIG. 7, the first group of signal traces 611 may include at least one first signal trace 6111.

The at least one third signal terminal A31 in the third group of terminals A3 is electrically connected to the at least one first signal terminal in the first group of terminals A1 by using the at least one signal 611a trace in the first group of signal traces 611 respectively, to transmit the first type of signal. The at least one third ground terminal A32 in the third group of terminals A3 is electrically connected to the at least one first ground terminal in the first group of terminals A1 by using the first reference ground GND1, to implement signal return.

In some embodiments, refer to FIG. 7. One third signal terminal A31 is provided in the third group of terminals A3. Correspondingly, one first signal terminal is also provided in the first group of terminals A1. One first signal trace 6111 is provided in the first group of signal traces 611. A first transmission path is formed by connecting the third signal terminal A31 in the third group of terminals A3, the first signal trace 6111 in the first group of signal traces 611, and the first signal terminal in the first group of terminals A1. The first transmission path is for transmitting the foregoing first type of signal. The first type of signal includes the radio frequency transmit signal and the radio frequency receive signal. Specifically, the radio frequency transmit signal and the radio frequency receive signal may be transmitted on the first transmission path in a manner of time division duplexing (time division duplexing, TDD).

The TDD is a duplexing manner of a communication system, for separating a receiving channel and a transferring channel (or an uplink and a downlink) in a mobile communication system. In the mobile communication system in the TDD mode, receiving and transferring are performed on different slots of a same frequency channel, namely, carrier, and guaranteed time is for separating the receiving channel and the transferring channel.

In some embodiments, refer to FIG. 7. A plurality of third ground terminals A32 may be provided in the third group of terminals A3. "Plurality of" is two or more, for example, seven third ground terminals A32 are provided. Correspondingly, a plurality of first ground terminals may also be provided in the first group of terminals A1. In this way, the first type of signal is returned by using the plurality of third ground terminals A32 and the plurality of first ground terminals, thereby improving return performance of the first type of signal.

In some embodiments, refer to FIG. 7. At least a part of the third ground terminals A32 in the third group of terminals A3 may be located between the third signal terminal A31 in the third group of terminals A3 and the fourth group of terminals A4. For example, in the embodiments shown in FIG. 7, four third ground terminals A32 in the third group of terminals A3 are located between the third signal terminal A31 and the fourth group of terminals A4.

In this way, a shielding function may be implemented by using the at least a part of the third ground terminals A32, thereby avoiding crosstalk between the first type of signal transmitted in the third signal terminal A31 and the second type of signal transmitted in the fourth group of terminals A4.

Similarly, at least a part of the first ground terminals in the first group of terminals A1 may be located between the first signal terminal and the second group of terminals A2, thereby avoiding crosstalk between the first type of signal transmitted in the first signal terminal and the second type of signal transmitted in the second group of terminals A2.

Similarly, still refer to FIG. 7. The fourth group of terminals A4 may include at least one fourth signal terminal A41 and at least one fourth ground terminal A42. In FIG. 7, the fourth signal terminal A41 is filled with section lines, and the fourth ground terminal A42 is filled with a black sold.

Correspondingly, the foregoing second group of terminals A2 may include at least one second signal terminal and at least one second ground terminal. The second group of signal traces 612 may include at least one second signal trace 6121. The at least one fourth signal terminal A41 in the fourth group of terminals A4 is electrically connected to the at least one second signal terminal in the second group of terminals A2 by using the at least one second signal trace 6121 in the second group of signal traces 612 respectively. The at least one fourth ground terminal A42 in the fourth group of terminals A4 is electrically connected to the at least one second ground terminal in the second group of terminals A2 by using the second reference ground GND2.

In the embodiments shown in FIG. 7, in the fourth group of terminals A4, a plurality of fourth signal terminals A41 may be provided, and a plurality of fourth ground terminals A42 may be provided. Correspondingly, in the second group of terminals A2, a plurality of second signal terminals may also be provided, and a plurality of second ground terminals may also be provided. A plurality of second signal trace 6121 may be provided in the second group of signal traces 612. The plurality of fourth signal terminals A41 in the fourth group of terminals A4 are electrically connected to the plurality of second signal terminals by using the plurality of second signal trace 6121 in the second group of signal traces 612 respectively.

Based on any one of the foregoing embodiments, the first reference ground GND1 and the second reference ground GND2 are spaced apart from each other. To be specific, there is a particular gap between the first reference ground GND1 and the second reference ground GND2, and the first reference ground GND1 is not in electrical conduction with the second reference ground GND2.

In this way, the first type of signal transmitted in the first group of signal traces 611 and the second type of signal transmitted in the second group of signal traces 612 are not common-grounded with each other. In this case, an isolation degree between the first type of signal and the second type of signal is large, so that crosstalk can be reduced to some extent. In addition, the first group of terminals A1 and the second group of terminals A2 are located in the first connector 62, the third group of terminals A3 and the fourth group of terminals A4 are located in the second connector 63, and the first type of signal and the second type of signal are introduced to the circuit board or output from the circuit board by using the first connector 62, and are output from the circuit board or introduced to the circuit board by using the second connector 63. Therefore, a quantity of connectors arranged on the electrical connection structure 6 and an external circuit board (the first circuit board 4 and the second circuit board 5) can be reduced, and sizes of the electrical connection structure 6 and the external circuit board can be reduced, thereby increasing a volume of another component (like a battery) arranged around the electrical connection structure and the external circuit board in an electronic device.

The following focuses on a structure of the circuit board 61.

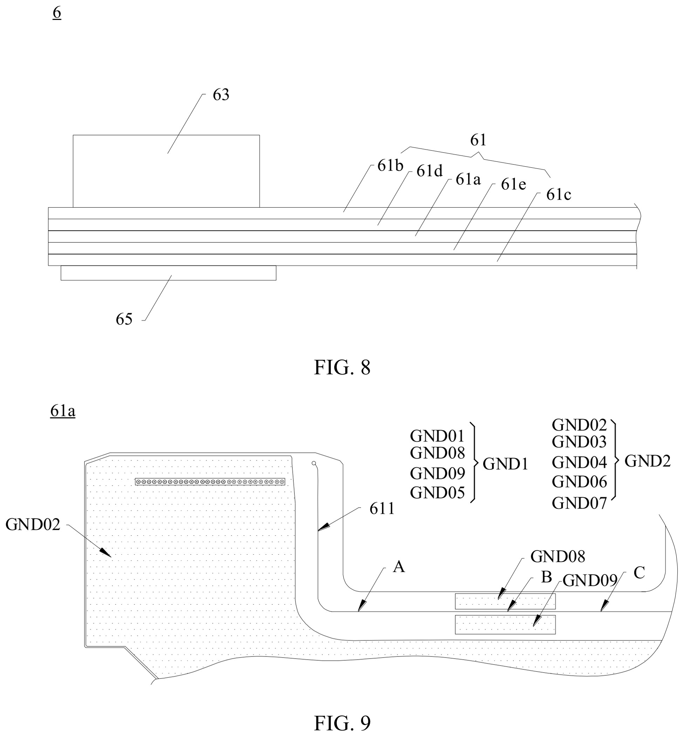

Specifically, refer to FIG. 8. FIG. 8 is a schematic diagram of a structure existing when the electrical connection structure 6 shown in FIG. 7 is viewed in a direction D3. The circuit board 61 may include a first metal layer 61a, a second metal layer 61b, and a third metal layer 61c.

A material of the first metal layer 61a, the second metal layer 61b, and the third metal layer 61c includes, but is not limited to, copper and an alloy of copper. The copper and alloy of copper have better electrical conduction properties, which can improve electrical properties of the electrical connection structure 6.

The first metal layer 61a and the second metal layer 61b are stacked and spaced away from each other. The third metal layer 61c is located on a side of the first metal layer 61a facing away from the second metal layer 61b. The third metal layer 61c and the first metal layer 61a are stacked and spaced away from each other.

In some embodiments, still refer to FIG. 8. A first insulation medium layer 61d is provided between the first metal layer 61a and the second metal layer 61b. A material of the first insulation medium layer 61d includes, but is not limited to, polyimide (polyimide, PI) and a polyester film. The first metal layer 61a and the second metal layer 61b are spaced apart from each other by using the first insulation medium layer 61d.

Similarly, a second insulation medium layer 61e is provided between the second metal layer 61b and the third metal layer 61c, so that the second metal layer 61b and the third metal layer 61c are spaced apart from each other by using the second insulation medium layer 61e.

Based on the foregoing embodiment, the first group of signal traces 611 and the first reference ground GND1 form a first signal transmission assembly, and the second group of signal traces 612 and the second reference ground GND2 form a second signal transmission assembly. The first signal transmission assembly and the second signal transmission assembly may be formed by at least a part of the first metal layer 61a, the second metal layer 61b, and the third metal layer 61c.

The following describes a specific structure of the first signal transmission assembly in the first metal layer 61a, the second metal layer 61b, and the third metal layer 61c.

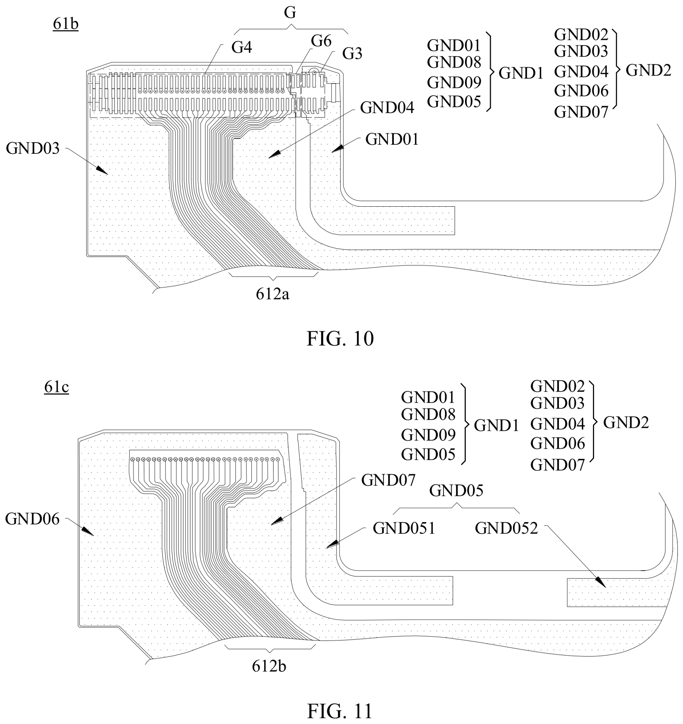

Refer to FIG. 9. FIG. 9 is a top view of a first metal layer 61a in the circuit board 61 shown in FIG. 8. The first group of signal traces 611 are formed by at least a part of the first metal layer 61a. Refer to FIG. 10. FIG. 10 is a top view of a second metal layer 61b in the circuit board 61 shown in FIG. 8. The first reference ground GND1 includes a first reference ground part GND01. The first reference ground part GND01 is formed by at least a part of the second metal layer 61b.

Based on the foregoing description, refer to FIG. 9 and FIG. 10. An orthographic projection of at least a part of the first group of signal traces 611 on the second metal layer 61b is located in the first reference ground part GND01. To be specific, an orthographic projection of a part of the first group of signal traces 611 on the second metal layer 61b may be located in the first reference ground part GND01, or an orthographic projection of the whole first group of signal traces 611 on the second metal layer 61b may be located in the first reference ground part GND01.

In this way, the at least a part of the first group of signal traces 611 may be shielded by using the first reference ground part GND01, thereby improving anti-interference performance of the first group of signal traces 611.

In the foregoing embodiment, optionally, refer to FIG. 9 mainly. The first group of signal traces 611 include a first segment A. The first segment A is a part of the first group of signal traces 611. Refer to FIG. 9 and FIG. 10. An orthographic projection of the first segment A on the second metal layer 61b is located in the first reference ground part GND01. In this way, anti-interference performance of the first segment A can be improved to some extent.

In some embodiments, still refer to FIG. 9. The first reference ground GND1 may further include an eighth reference ground part GND08 and a ninth reference ground part GND09.

When the first group of signal traces 611 are formed by a part of the first metal layer 61a, the eighth reference ground part GND08 and the ninth reference ground part GND09 are formed by another part of the first metal layer 61a. In addition, the eighth reference ground part GND08 is located on one side of at least a part of the first group of signal traces 611, and the ninth reference ground part GND09 is located on the other side of the at least a part of the first group of signal traces 611.

In this way, the at least a part of the first group of signal traces 611 may be shielded by using the eighth reference ground part GND08 and the ninth reference ground part GND09. In addition, the eighth reference ground part GND08, the ninth reference ground part GND09, and the at least a part of the first group of signal traces 611 located between the eighth reference ground part GND08 and the ninth reference ground part GND09 form a coplanar waveguide. An insertion loss of the coplanar waveguide is small, thereby helping improve transmission efficiency of a radio frequency signal.

In the foregoing embodiment, optionally, still refer to FIG. 9. The first group of signal traces 611 further include a second segment B. The second segment B is a part of the first group of signal traces 611. The eighth reference ground part GND08 is located on one side of the second segment B, and the ninth reference ground part GND09 is located on the other side of the second segment B. In this way, the eighth reference ground part GND08, the second segment B, and the ninth reference ground part GND09 may form a coplanar waveguide structure, thereby reducing an insertion loss of the first group of signal traces 611 to some extent and improving the transmission efficiency of the radio frequency signal.

In some embodiments, a part of the circuit board 61 on which the second segment B, the eighth reference ground part GND08, and the ninth reference ground part GND09 are located may pass through a rotating shaft mechanism. The part of the circuit board includes a small quantity of metal layers, and therefore is flexible and easier to be folded.

In some embodiments, the first reference ground part GND01, the eighth reference ground part GND08, and the ninth reference ground part GND09 may be electrically connected as a whole. Specifically, the first reference ground part GND01, the eighth reference ground part GND08, and the ninth reference ground part GND09 may be electrically connected as a whole by using a first plated via hole (not shown in the figure) and another metal region. The first plated via hole may be arranged in the first insulation medium layer 61d.

Refer to FIG. 11. FIG. 11 is a top view of a third metal layer 61c in the circuit board 61 shown in FIG. 8. The first reference ground GND1 further includes a fifth reference ground part GND05. The fifth reference ground part GND05 is formed by at least a part of the third metal layer 61c, and the fifth reference ground part GND05 is electrically connected to the first reference ground part GND01. Specifically, the fifth reference ground part GND05 may be electrically connected to the first reference ground part GND01 by using a second plated via hole (not shown in the figure) and another metal region. The second plated via hole may be arranged on the first insulation medium layer 61d and the second insulation medium layer 61e.

Based on the foregoing description, an orthographic projection of the at least a part of the first group of signal traces 611 on the third metal layer 61c is located in the fifth reference ground part GND05. To be specific, an orthographic projection of a part of the first group of signal traces 611 on the third metal layer 61c may be located in the fifth reference ground part GND05, or an orthographic projection of the whole first group of signal traces 611 on the third metal layer 61c may be located in the fifth reference ground part GND05.

In this way, the at least a part of the first group of signal traces 611 may be shielded by using the fifth reference ground part GND05, thereby further improving the anti-interference performance of the first group of signal traces 611.

In some embodiments, still refer to FIG. 11. The fifth reference ground part GND05 includes a first reference ground unit GND051. Refer to FIG. 9 and FIG. 11. An orthographic projection of the first segment A on the third metal layer 61c is located in the first reference ground unit GND051, and an orthographic projection of the first reference ground unit GND051 on the first metal layer 61a overlaps with the first reference ground part GND01.

In this way, the first reference ground part GND01, the first segment A, and the first reference ground unit GND051 form a stripe structure, to further improve anti-interference performance of the first segment A.

Based on the foregoing embodiment, optionally, still refer to FIG. 11. The fifth reference ground part GND05 further includes a second reference ground unit GND052. The second reference ground unit GND052 and the first reference ground unit GND051 are spaced apart from each other, and the second reference ground unit GND052 is electrically connected to the first reference ground unit GND051. Specifically, the second reference ground unit GND052 may be electrically connected to the first reference ground unit GND051 by using another metal region (not shown in the figure).

Based on this, refer back to FIG. 9. The first group of signal traces 611 further include a third segment C. In some embodiments, the third segment C is connected to an end of the second segment B far away from the first segment A. An orthographic projection of the third segment C on the third metal layer 61c is located in the second reference ground unit GND052.

In this way, the third segment C and the second reference ground unit GND052 form a microstrip structure. The third segment C can be shielded by using second reference ground unit GND052, thereby improving anti-interference performance of the third segment C.

According to the description of the foregoing embodiments, the first signal transmission assembly may simultaneously have the stripe structure, the coplanar waveguide structure, and the microstrip structure; the first signal transmission assembly may have two of the stripe structure, the coplanar waveguide structure, and the microstrip structure; or the first signal transmission assembly may have only one of the stripe structure, the coplanar waveguide structure, and the microstrip structure. This is not specifically limited in this application.

The following describes a specific structure of the second signal transmission assembly in the first metal layer 61a, the second metal layer 61b, and the third metal layer 61c.

Refer back to FIG. 9 and FIG. 10. Refer to FIG. 10 mainly. When the first group of signal traces 611 are formed by a part of the first metal layer 61a, and the first reference ground part GND01 is formed by a part of the second metal layer 61b, the second group of signal traces 612 include the first part of signal traces 612a. The first part of signal traces 612a are formed by another part of the second metal layer 61b. The first part of signal traces 612a and the first reference ground part GND01 are spaced apart from each other. To be specific, the first part of signal traces 612a are independent of and are not in electrical conduction with the first reference ground part GND01.

Based on the foregoing description, refer to FIG. 9 mainly. The second reference ground GND2 includes a second reference ground part GND02. The second reference ground part GND02 is formed by another part of the first metal layer 61a.

The second reference ground part GND02 and the first group of signal traces 611 are spaced apart from each other. To be specific, the second reference ground part GND02 is independent of and is not in electrical conduction with the first group of signal traces 611.

Refer to FIG. 9 and FIG. 10. An orthographic projection of at least a part of the first part of signal traces 612a on the first metal layer 61a is located in the second reference ground part GND02. To be specific, an orthographic projection of a part of the first part of signal traces 612a on the first metal layer 61a may be located in the second reference ground part GND02, or an orthographic projection of the whole first metal layer 61a may be located in the second reference ground part GND02.

In this way, the at least a part of the first part of signal traces 612a may be shielded by using the second reference ground part GND02, thereby improving anti-interference performance of the first part of signal traces 612a.

In some embodiments, refer to FIG. 9 and FIG. 10. An orthographic projection of the whole first part of signal traces 612a on the first metal layer 61a is located in the second reference ground part GND02. In this way, the whole first part of signal traces 612a may be shielded by using the second reference ground part GND02, thereby effectively improving anti-interference performance of the first part of signal traces 612a.

Based on the foregoing embodiment, refer to FIG. 10 mainly. The second reference ground GND2 further includes a third reference ground part GND03 and a fourth reference ground part GND04. The third reference ground part GND03 and the fourth reference ground part GND04 are formed by another part of the second metal layer 61b. The third reference ground part GND03 and the fourth reference ground part GND04 are electrically connected to the foregoing second reference ground part GND02. Specifically, the third reference ground part GND03 and the fourth reference ground part GND04 may be electrically connected to the second reference ground part GND02 by using a third plated via hole (not shown in the figure). The third plated via hole may be arranged in the first insulation medium layer 61d.

Based on the foregoing description, the third reference ground part GND03 is located on one side of the first part of signal traces 612a, and the fourth reference ground part GND04 is located on the other side of the first part of signal traces 612a.

In this way, the first part of signal traces 612a may be shielded in a plane on which the second metal layer 61b is located by using the third reference ground part GND03 and the fourth reference ground part GND04, thereby improving the anti-interference performance of the first part of signal traces 612a. In addition, an area of the second reference ground GND2 is increased, thereby improving the signal return performance. In addition, on the premise of ensuring that the area of the second reference ground GND2 remains unchanged, a part of the second reference ground GND2 is arranged on the first metal layer 61a, and another part of the second reference ground GND2 is arranged on the second metal layer 61b. In this way, through the stacked arrangement, a footprint of a second signal transmission assembly on the circuit board 61 can be reduced, thereby helping reduce a volume of the electrical connection structure 6 and facilitating mounting in the electronic device with limited space.

In some embodiments, refer to FIG. 11. Refer to FIG. 9 and FIG. 11. When the fifth reference ground part GND05 is formed by a part of the third metal layer 61c, the second group of signal traces 612 further include a second part of signal traces 612b. The second part of signal traces 612b are formed by another part of the third metal layer 61c, and an orthographic projection of at least a part of the second part of signal traces 612b on the first metal layer 61a is located in the second reference ground part GND02.

In this way, the second part of signal traces 612b and the first part of signal traces 612a may be isolated from each other by using the second reference ground part GND02, thereby avoiding interference between the second part of signal traces and the first part of signal traces.

Based on the foregoing embodiment, still refer to FIG. 11. The second reference ground GND2 further includes a sixth reference ground part GND06 and a seventh reference ground part GND07. The sixth reference ground part GND06 and the seventh reference ground part GND07 are formed by another part of the third metal layer 61c. The sixth reference ground part GND06 and the seventh reference ground part GND07 are electrically connected to the second reference ground part GND02. Specifically, the sixth reference ground part GND06 and the seventh reference ground part GND07 may be electrically connected to the second reference ground part GND02 by using a fourth plated via hole (not shown in the figure). The fourth plated via hole is arranged in the second insulation medium layer 61e.

Based on the foregoing description, the sixth reference ground part GND06 is located on one side of the second part of signal traces 612b, and the seventh reference ground part GND07 is located on the other side of the second part of signal traces 612b.

In this way, the second part of signal traces 612b may be shielded in a plane on which the third metal layer 61c is located by using the sixth reference ground part GND06 and the seventh reference ground part GND07, thereby improving anti-interference performance of the second part of signal traces 612b. In addition, the area of the second reference ground GND2 is increased, thereby improving the signal return performance. In addition, on the premise of ensuring that the area of the second reference ground GND2 remains unchanged, another part of the second reference ground GND2 is arranged on the third metal layer 61c. In this way, through the stacked arrangement, the footprint of the second signal transmission assembly on the circuit board 61 can be reduced, thereby helping reduce the volume of the electrical connection structure 6 and facilitating mounting in the electronic device with the limited space.

According to the description of the foregoing embodiments, the second signal transmission assembly is distributed in three metal layers. A middle metal layer (corresponding to the first metal layer 61a) of the three metal layers is provided with a reference ground, and metal layers on two sides (including the second metal layer 61b and the third metal layer 61c) are provided with signal cables. In this way, a large quantity of signal cables may be provided, and crosstalk between a plurality of signal cables may also be avoided. In some other embodiments, the second signal transmission assembly may be arranged in only one of the first metal layer 61a, the second metal layer 61b, and the third metal layer 61c, or the second signal transmission assembly may be arranged in another metal layer in addition to the first metal layer 61a, the second metal layer 61b, and the third metal layer 61c. This is not specifically limited in this application.

Based on the foregoing embodiment, the first connector 62 and the second connector 63 are located on a side of the second metal layer 61b facing away from the first metal layer 61a.

Specifically, refer back to FIG. 6A. A first pad set (not shown in the figure) may be arranged at a location corresponding to the first connector 62 on the circuit board 61. Specifically, the first pad set may be formed by a part of the second metal layer 61b shown in FIG. 10. The first pad set includes a plurality of pads. A terminal of the first connector 62 is soldered to the first pad set.

The first pad set may include a first group of pads and a second group of pads. The first group of pads and the second group of pads include at least one pad. Based on this, on the first connector 62, the first group of terminals A1 is soldered to the first group of pads, and the second group of terminals A2 are soldered to the second group of pads.

In this way, the first connector 62 may be electrically and fixedly connected to the circuit board 61 by using the first pad set.

Similarly, still refer to FIG. 6A. A second pad set G may be arranged at a location corresponding to the second connector 63 on the circuit board 61. Refer to FIG. 10. The second pad set G may be formed by a part of the second metal layer 61b shown in FIG. 10. The second pad set G includes a plurality of pads. A terminal of the second connector 63 is soldered to the second pad set G.

Refer to FIG. 10. The second pad set G may include a third group of pads G3 and a fourth group of pads G4. The third group of pads G3 and the fourth group of pads G4 include at least one pad. Based on this, refer to FIG. 7. On the second connector 63, the third group of terminals A3 are soldered to the third group of pads G3, and the fourth group of terminals A4 are soldered to the fourth group of pads G4.

In this way, the second connector 63 can be electrically and fixedly connected to the circuit board 61 by using the second pad set G.

Based on the foregoing description, refer to FIG. 9 and FIG. 10. Two ends of the first group of signal traces 611 may be respectively connected to a first pad in the first pad set and a third pad in the second pad set G by using a plated via hole in the second insulation medium layer 61e. The first pad is a pad in the first pad set for soldering the first signal terminal, and the third pad is a pad in the second pad set G for soldering the third signal terminal A31. This structure is simple and has a neat appearance.

Similarly, refer to FIG. 10 and FIG. 11. Two ends of the second part of signal traces 612b in the third metal layer 61c may also be respectively connected to a second pad in the first pad set and a fourth pad in the second pad set G by using a plated via hole in the first insulation medium layer 61d and a plated via hole in the second insulation medium layer 61e. The second pad is a pad in the first pad set for soldering the second signal terminal, and the fourth pad is a pad in the second pad set G for soldering the fourth signal terminal A41. This structure is simple and has a neat appearance.

Based on any one of the foregoing embodiments, refer back to FIG. 6B. The first connector 62 further includes a fifth group of terminals A5. The fifth group of terminals A5 are located between the first group of terminals A1 and the second group of terminals A2. The fifth group of terminals A5 include at least one terminal. In the embodiment shown in FIG. 6B, three terminals in the fifth group of terminals A5 are provided.

Based on the foregoing embodiment, the first pad set further includes a fifth group of pads. The fifth group of pads are located at a location corresponding to a fifth group of terminals A5 on the circuit board 61. The fifth group of pads include at least one pad. In some embodiments, a quantity of pads in the fifth group of pads is equal to a quantity of terminals in the fifth group of terminals A5, and pads in the fifth group of pads are in a one-to-one correspondence with terminals in the fifth group of terminals A5. The fifth group of terminals A5 are soldered to the fifth group of pads.

Based on the foregoing description, the fifth group of pads are located between the first reference ground GND1 and the second reference ground GND2. The fifth group of pads and the first reference ground GND1 are spaced apart from each other, and the fifth group of pads and the second reference ground GND2 are spaced apart from each other. That is, the fifth group of pads are independent of and are not in electrical conduction with the first reference ground GND1 and the second reference ground GND2.

In this way, isolation may be formed by using the fifth group of terminals A5, thereby avoiding crosstalk between the first type of signal transmitted in the first group of terminals A1 and the second type of signal transmitted in the second group of terminals A2.

Specifically, refer back to FIG. 5B. The fourth connector 43 further includes an eleventh group of terminals A11. The eleventh group of terminals A11 are located between the seventh group of terminals A7 and the eighth group of terminals A8, and the eleventh group of terminals A11 are electrically connected to a reference ground layer (not shown in the figure) in the first circuit board 4. Based on this, the eleventh group of terminals A11 are in cooperation connection with the foregoing fifth group of terminals A5. Therefore, the fifth group of terminals A5 are connected to a reference ground of the first circuit board 4, so that the fifth group of terminals A5 can implement electromagnetic shielding. In this way, mutual crosstalk between the first type of signal transmitted in the first group of terminals A1 and the second type of signal transmitted in the second group of terminals A2 can be avoided.

Similarly, refer to FIG. 6C. The second connector 63 further includes a sixth group of terminals A6. The sixth group of terminals A6 are located between the third group of terminals A3 and the fourth group of terminals A4. The sixth group of terminals A6 include at least one terminal. In the embodiment shown in FIG. 6C, three terminals in the sixth group of terminals A6 are provided.

Based on the foregoing embodiment, refer to FIG. 10. The first pad set G further includes a sixth group of pads G6. The sixth group of pads G6 are located at a location corresponding to the sixth group of terminals A6 on the circuit board 61. The sixth group of pads G6 include at least one pad. In some embodiments, a quantity of pads in the sixth group of pads G6 is equal to a quantity of terminals in the sixth group of terminals A6, and pads in the sixth group of pads G6 are in a one-to-one correspondence with terminals in the sixth group of terminals A6. The sixth group of terminals A6 are soldered to the sixth group of pads G6.

Based on the foregoing description, the sixth group of pads G6 are located between the first reference ground GND1 and the second reference ground GND2. The sixth group of pads G6 and the first reference ground GND1 are spaced apart from each other, and the sixth group of pads G6 and the second reference ground GND2 are also spaced apart from each other. That is, the sixth group of pads G6 are not in electrical conduction with both the first reference ground GND1 and the second reference ground GND2.

In this way, the sixth group of pads G6 may be in cooperation connection with a ground terminal in a contra lateral connector (that is, the fifth connector 51), to form isolation, thereby avoiding mutual crosstalk between the first type of signal transmitted in the third group of terminals A3 and the second type of signal transmitted in the fourth group of terminals A4.

Specifically, refer back to FIG. 5C. The fifth connector 51 further includes a twelfth group of terminals A12. The twelfth group of terminals A12 are located between the ninth group of terminals A9 and the tenth group of terminals A10, and the twelfth group of terminals A12 are electrically connected to a reference ground layer in the second circuit board 5. Based on this, the twelfth group of terminals A12 are in cooperation connection with the foregoing sixth group of terminals A6. Therefore, the sixth group of terminals A6 are connected to the reference ground of the second circuit board 5, so that the sixth group of terminals A6 can implement electromagnetic shielding. In this way, mutual crosstalk between the first type of signal transmitted in the third group of terminals A3 and the second type of signal transmitted in the fourth group of terminals A4 can be avoided.

In some embodiments, refer back to FIG. 5A. The electrical connection structure 6 further includes a first reinforcing member 64. The first reinforcing member 64 is located on a surface of the circuit board 61 facing away from the first connector 62. An orthographic projection of the first connector 62 on the circuit board 61 overlaps with an orthographic projection of the first reinforcing member 64 on the circuit board 61. The first reinforcing member 64 is an insulating member.

Specifically, a material of the first reinforcing member 64 includes, but is not limited to, a non-metal like FR-4 epoxy glass-cloth laminate, polycarbonate (polycarbonate, PC), PC+glass fiber, or ABS plastic (acrylonitrile butadiene styrene plastic). FR-4 is a code name for a flame-resistant material grade.

In this way, structural strength of the part of the circuit board 61 to which the first connector 62 is connected can be increased by using the first reinforcing member 64, thereby facilitating a plug-in operation. In addition, because the first reinforcing member 64 is the insulating member, capacitive coupling effects between the first reference ground GND1 and the first reinforcing member 64, and between the second reference ground GND2 and the first reinforcing member 64 can be avoided. In this way, mutual crosstalk between the first reference ground GND1 and the second reference ground GND2 by using the first reinforcing member 64 is avoided, thereby increasing the isolation degree between the first type of signal and the second type of signal.

The first reinforcing member 64 may be adhered to the circuit board 61 by using an adhesive material. The adhesive material may be a conductive adhesive or a non-conductive adhesive. When the adhesive material is the conductive adhesive, the adhesive material may be arranged between the circuit board 61 and the first reinforcing member 64 in a glue dispensing manner. In this way, forming of an entire layer of the conductive adhesive material is avoided, thereby avoiding mutual crosstalk between the first reference ground GND1 and the second reference ground GND2 by using the adhesive material.

Similarly, refer to FIG. 5A. The electrical connection structure 6 further includes a second reinforcing member 65. The second reinforcing member 65 is located on a surface of the circuit board 61 facing away from the second connector 63. An orthographic projection of the second connector 63 on the circuit board 61 overlaps with an orthographic projection of the second reinforcing member 65 on the circuit board 61. The second reinforcing member 65 is an insulating member.

In this way, structural strength of a part on the circuit board 61 to which the second connector 63 is connected can be increased by using the second reinforcing member 65, thereby facilitating a plug-in operation. In addition, because the second reinforcing member 65 is an insulating member, capacitive coupling effects between the first reference ground GND1 and the second reinforcing member 65, and between the second reference ground GND2 and the second reinforcing member 65 can be avoided. In this way, mutual crosstalk between the first reference ground GND1 and the second reference ground GND2 is avoided by using the second reinforcing member 65, thereby increasing the isolation degree between the first type of signal and the second type of signal.

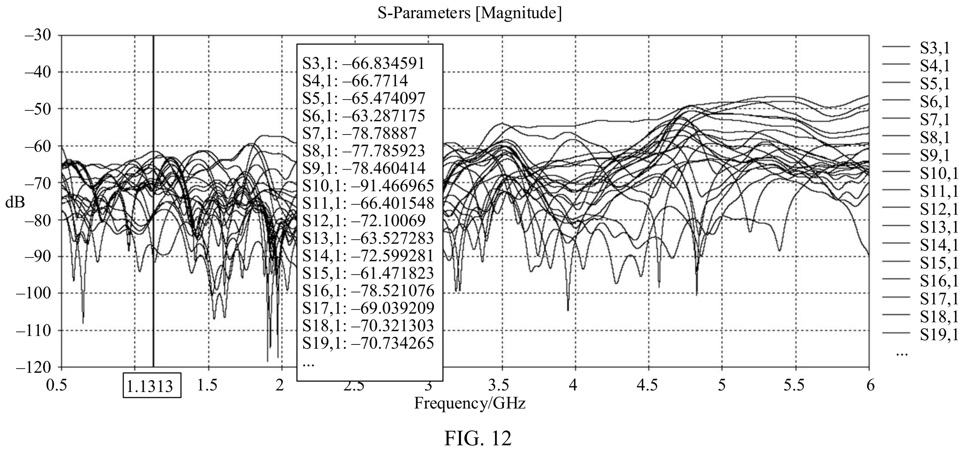

To verify an isolation effect of the electrical connection structure 6 provided in this application separately on the first type of signal and the second type of signal, refer to FIG. 12. FIG. 12 is a graph of variation of an isolation degree between a first type of signal and a second type of signal transmitted in the electrical connection structure 6 shown in FIG. 7 with a frequency (Frequency) in a simulation experiment. In FIG. 12, S3,1, S4,1, S5,1, S6,1, S7,1, S8,1, S9,1, S10,1, S11,1, S12,1, S13,1, S14,1, S15,1, S16,1, S17,1, S18,1, and S19,1 are respectively isolation degrees between a first type of signal transmitted in a first signal trace 6111 in a first group of signal traces 611 and second type of signals transmitted in different second signal traces 6121 in the second group of signal traces 612. It can be learned from FIG. 12 that, at a frequency of 1.1313 GHz, the isolation degree between the first type of signal and different second type of signals is between -61.471823 dB and -91.466965 dB.

For a comparative electrical connection structure, a structure and size of the comparative electrical connection structure are approximately the same as the structure and size of the electrical connection structure 6 shown in FIG. 7. However, in the comparative electrical connection structure, the first reference ground GND1 and the second reference ground GND2 are connected to each other. In addition, the fifth group of terminals A5 that perform an isolation function are not between the first group of terminals A1 and the second group of terminals A2, and the sixth group of terminals A6 that perform an isolation function are not between the third group of terminals A3 and the fourth group of terminals A4. Further, a material of the first reinforcing member 64 and the second reinforcing member 65 is metal.

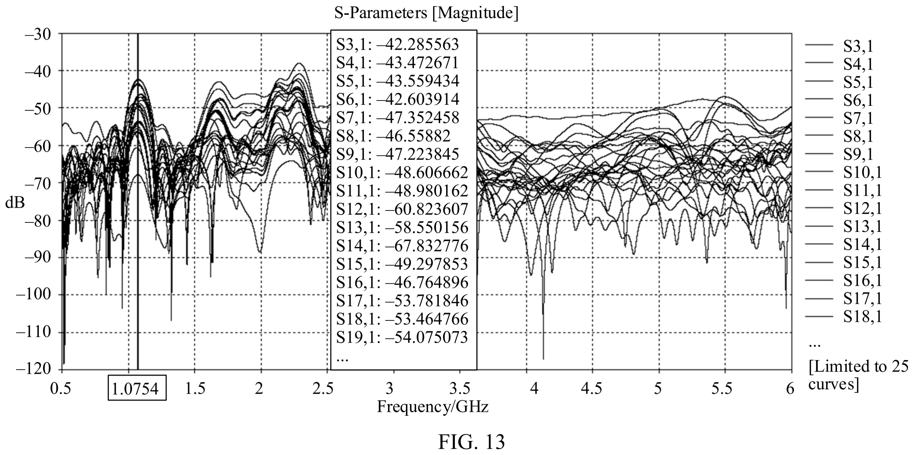

Refer to FIG. 13. FIG. 13 is a graph of variation of an isolation degree between a first type of signal and a second type of signal of a comparative electrical connection structure with a frequency in a simulation experiment. Similarly, in FIG. 13, S3,1, S4,1, S5,1, S6,1, S7,1, S8,1, S9,1, S10,1, S11,1, S12,1, S13,1, S14,1, S15,1, S16,1, S17,1, S18,1, and S19,1 are respectively isolation degrees between a first type of signal transmitted in a first signal trace 6111 in a first group of signal traces 611 and second type of signals transmitted in different second signal trace 6121 in the second group of signal traces 612. It can be learned from FIG. 13 that, at a frequency of 1.0754 GHz, the isolation degree between the first type of signal and different second type of signals is between -42.285563 dB and -60.823607 dB.

It can be known by comparing the simulation results shown in FIG. 12 and FIG. 13 that, compared with the isolation degree between the first type of signal and the second type of signal in the comparative electrical connection structure, the isolation degree between the first type of signal and the second type of signal in the electrical connection structure 6 provided in this application is increased by more than 10 dB. Therefore, an isolation effect is relatively good, and crosstalk between the two signals can be avoided.

The foregoing embodiments are described by using an example in which the first group of terminals A1 are a part of terminals of the first connector 62, and the second group of terminals A2 are another part of the terminals of the first connector 62; and the third group of terminals A3 are a part of terminals of the second connector 63, and the fourth group of terminals A4 are another part of the terminals of the second connector 63.

In some other embodiments, on the basis that the first group of terminals A1 are a part of terminals of the first connector 62, and the second group of terminals A2 are another part of the terminals of the first connector 62, the third group of terminals A3 and the fourth group of terminals A4 may not be terminals of the second connector 63. For example, the third group of terminals A3 and the fourth group of terminals A4 are independently arranged on the circuit board 61, for example, are pads on the circuit board 61; the third group of terminals A3 and the fourth group of terminals A4 are terminals of two or more connectors on the circuit board 61; or a part of terminals of the third group of terminals A3 and the fourth group of terminals A4 are terminals in the connector, and another part of terminals are independent of the connector, for example, another part of terminals may be pads on the circuit board 61. This is not specifically limited in this application.

In this way, the first type of signal and the second type of signal are introduced to the circuit board 61 or output from the circuit board 61 by using the first connector 62. A quantity of connectors arranged on the electrical connection structure 6 and an external circuit board can be reduced, and sizes of the electrical connection structure 6 and the external circuit board can be reduced, thereby increasing a volume of another component (like a battery) arranged around the electrical connection structure 6 and the external circuit board in an electronic device.

In addition, the foregoing embodiments are described by using an example in which the third group of terminals A3 and the fourth group of terminals A4 are both connected to the second circuit board 5. In other embodiments, the third group of terminals A3 and the fourth group of terminals A4 may be respectively connected to two or more circuit boards. This is not specifically limited in this application.

In addition, the first connector 62 may further include another group of terminals, in addition to the first group of terminals A1, the second group of terminals A2, and the fifth group of terminals A5. Based on this, in addition to the third group of terminals A3 and the fourth group of terminals A4, the electrical connection structure 6 may further include another group of terminals. The another group of terminals are electrically connected to the another group of terminals in the first connector 62 by using the circuit board 61, to implement transmission of another baseband signal or radio frequency signal. This is not specifically limited in this application.

The foregoing embodiments are embodiments in which the first circuit board 4 and the second circuit board 5 are respectively accommodated in the first housing 21 and the second housing 22. In other embodiments, the first circuit board 4 and the second circuit board 5 may alternatively be accommodated in the same housing.

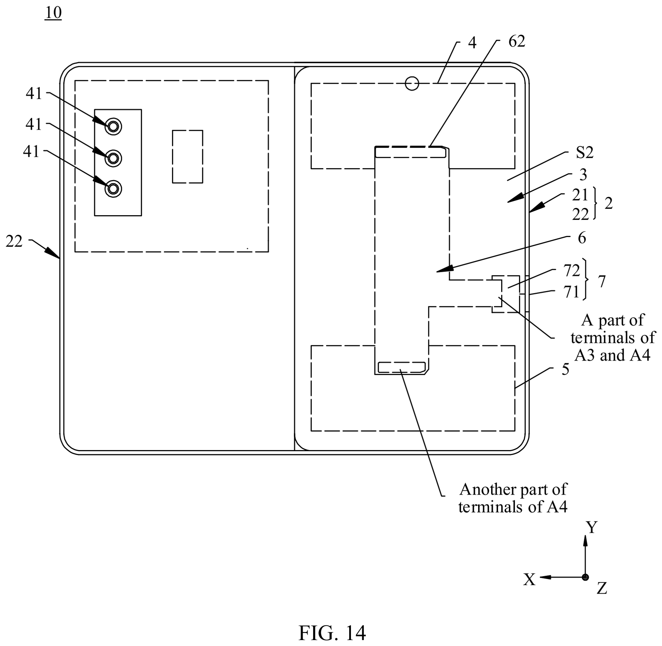

For example, refer to FIG. 14. FIG. 14 is a schematic diagram of a structure of an electronic device 10 according to some other embodiments of this application. In this embodiment, the first circuit board 4 and the second circuit board 5 are both accommodated in a first housing 21. Based on this, the foregoing electrical connection structure 6 may further be connected among the first circuit board 4, the second circuit board 5, and the control circuit board 72. Specifically, the first connector 62 of the electrical connection structure 6 is connected to the first circuit board 4, and a part of terminals of the third group of terminals A3 and the fourth group of terminals A4 of the foregoing electrical connection structure 6 are electrically connected to the control circuit board 72, thereby implementing transmission of the radio frequency signal and the baseband signal between the first circuit board 4 and the control circuit board 72 by using the electrical connection structure 6. Another part of terminals of the fourth group of terminals A4 of the foregoing electrical connection structure 6 are electrically connected to the second circuit board 5, thereby implementing transmission of the baseband signal between the first circuit board 4 and the second circuit board 5 by using the electrical connection structure 6.

In description of this specification, the described specific features, structures, materials, or characteristics may be combined in a proper manner in any one or more of embodiments or examples.

Finally, it should be noted that the foregoing embodiments are only used to describe the technical solutions in this application, but are not used to limit this application. Although this application has been described in detail with reference to the foregoing embodiments, it should be understood by a person of ordinary skill in the art that the technical solutions described in the foregoing embodiments may still be modified, or some technical features thereof may be equivalently replaced. These modifications or replacements do not make the essence of the corresponding technical solutions depart from the spirit and scope of the technical solutions in embodiments of this application.

## Claims

1. An electrical connection structure, comprising:
a circuit board, wherein the circuit board comprises a first group of signal traces, a second group of signal traces, a first reference ground, and a second reference ground; and the first reference ground faces the first group of signal traces, the second reference ground faces the second group of signal traces, and the first reference ground and the second reference ground are spaced apart from each other;
a first connector, wherein the first connector is arranged on the circuit board, and the first connector comprises a first group of terminals and a second group of terminals; and
a third group of terminals and a fourth group of terminals, wherein the third group of terminals and the fourth group of terminals are arranged on the circuit board, the third group of terminals are electrically connected to the first group of terminals by using the first group of signal traces and the first reference ground, and the fourth group of terminals are electrically connected to the second group of terminals by using the second group of signal traces and the second reference ground.

2. The electrical connection structure according to claim 1, wherein the circuit board comprises a first metal layer and a second metal layer that are stacked and spaced away from each other; and
the first group of signal traces are formed by at least a part of the first metal layer, the first reference ground comprises a first reference ground part, the first reference ground part is formed by at least a part of the second metal layer, and an orthographic projection of at least a part of the first group of signal traces on the second metal layer is located in the first reference ground part.

3. The electrical connection structure according to claim 2, wherein
when the first group of signal traces are formed by a part of the first metal layer and the first reference ground part is formed by a part of the second metal layer,
the second group of signal traces comprise a first part of signal traces, the first part of signal traces are formed by another part of the second metal layer, the first part of signal traces and the first reference ground part are spaced apart from each other, the second reference ground comprises a second reference ground part, the second reference ground part is formed by another part of the first metal layer, and the second reference ground part and the first group of signal traces are spaced apart from each other; and
an orthographic projection of at least a part of the first part of signal traces on the first metal layer is located in the second reference ground part.

4. The electrical connection structure according to claim 3, wherein the second reference ground further comprises a third reference ground part and a fourth reference ground part, and the third reference ground part and the fourth reference ground part are formed by another part of the second metal layer; and
the third reference ground part and the fourth reference ground part are electrically connected to the second reference ground part, the third reference ground part is located on one side of the first part of signal traces, and the fourth reference ground part is located on the other side of the first part of signal traces.

5. The electrical connection structure according to any one of claims 2 to 4, wherein the circuit board further comprises a third metal layer, the third metal layer is located on a side of the first metal layer facing away from the second metal layer, and the third metal layer and the first metal layer are stacked and spaced away from each other; and
the first reference ground further comprises a fifth reference ground part, the fifth reference ground part is formed by at least a part of the third metal layer, the fifth reference ground part is electrically connected to the first reference ground part, and an orthographic projection of at least a part of the first group of signal traces on the third metal layer is located in the fifth reference ground part.

6. The electrical connection structure according to claim 5, wherein when the fifth reference ground part is formed by a part of the third metal layer,
the second group of signal traces further comprise a second part of signal traces, the second part of signal traces are formed by another part of the third metal layer, and an orthographic projection of at least a part of the second part of signal traces on the first metal layer is located in the second reference ground part.

7. The electrical connection structure according to claim 6, wherein the second reference ground further comprises a sixth reference ground part and a seventh reference ground part, and the sixth reference ground part and the seventh reference ground part are formed by another part of the third metal layer; and
the sixth reference ground part and the seventh reference ground part are electrically connected to the second reference ground part, the sixth reference ground part is located on one side of the second part of signal traces, and the seventh reference ground part is located on the other side of the second part of signal traces.

8. The electrical connection structure according to any one of claims 1 to 7, wherein the circuit board comprises the first metal layer, and the first reference ground comprises an eighth reference ground part and a ninth reference ground part; and
the first group of signal traces are formed by a part of the first metal layer, the eighth reference ground part and the ninth reference ground part are formed by another part of the first metal layer, the eighth reference ground part is located on one side of at least a part of the first group of signal traces, and the ninth reference ground part is located on the other side of the at least a part of the first group of signal traces.

9. The electrical connection structure according to any one of claims 1 to 8, wherein the first group of terminals comprise one first signal terminal and a plurality of first ground terminals; and
at least a part of the plurality of first ground terminals are located between the first signal terminal and the second group of terminals.

10. The electrical connection structure according to any one of claims 1 to 9, wherein the first connector further comprises a fifth group of terminals, and the fifth group of terminals are located between the first group of terminals and the second group of terminals;
a fifth group of pads are arranged on the circuit board, the fifth group of pads are located between the first reference ground and the second reference ground, the fifth group of pads and the first reference ground are spaced apart from each other, and the fifth group of pads and the second reference ground are spaced apart from each other; and the fifth group of terminals are soldered to the fifth group of pads.

11. The electrical connection structure according to any one of claims 1 to 10, further comprising:
a first reinforcing member, wherein the first reinforcing member is located on a surface of the circuit board facing away from the first connector, an orthographic projection of the first connector on the circuit board overlaps with an orthographic projection of the first reinforcing member on the circuit board, and the first reinforcing member is an insulating member.

12. The electrical connection structure according to any one of claims 1 to 11, further comprising: a second connector, wherein the second connector is arranged on the circuit board, the third group of terminals are a part of terminals of the second connector, and the fourth group of terminals are another part of the terminals of the second connector.

13. The electrical connection structure according to any one of claims 1 to 12, wherein the first group of signal traces are for transmitting a radio frequency signal, and the second group of signal traces are for transmitting a baseband signal.

14. The electrical connection structure according to any one of claims 1 to 13, wherein the circuit board is a flexible printed circuit.

15. The electrical connection structure according to any one of claims 1 to 14, wherein the circuit board comprises a first circuit board part and a second circuit board part, an end of the first circuit board part along a length direction of the first circuit board part is connected to an end of the second circuit board part along a length direction of the second circuit board part, and the length direction of the first circuit board part intersects with the length direction of the second circuit board part.

16. The electrical connection structure according to claim 15, wherein the circuit board is provided with an opening, the opening comprises a first opening part and a second opening part, the first opening part is located at an end portion of the first circuit board part facing the second circuit board part, and the first opening part extends along the length direction of the first circuit board part; and
the second opening part is arranged at an end portion of the second circuit board part facing the first circuit board part and is in communication with the first opening part, and the second opening part extends along the length direction of the second circuit board part.

17. An electronic device, comprising:
a first circuit board, wherein a fourth connector is arranged on the first circuit board; and
the electrical connection structure according to any one of claims 1 to 16, wherein the first connector of the electrical connection structure is electrically connected to the fourth connector of the first circuit board.

18. The electronic device according to claim 17, further comprising:
a second circuit board, wherein the third group of terminals and the fourth group of terminals of the electrical connection structure are electrically connected to the second circuit board.

19. The electronic device according to claim 18, wherein the electronic device comprises a first screen, a first housing, a second housing, and a rotating shaft mechanism;
the first screen comprises a first screen part and a second screen part connected to the first screen part;
the first screen part is connected to the first housing, the second screen part is connected to the second housing, and the rotating shaft mechanism is connected between the first housing and the second housing; and
the second circuit board is arranged in the first housing, the first circuit board is arranged in the second housing, and the electrical connection structure passes through the rotating shaft mechanism.
